(19) **Europäisches Patentamt / European Patent Office / Office européen des brevets**

(11) **EP 4 449 134 B1**

(12) **FASCICULE DE BREVET EUROPEEN**

(45) Date de publication et mention de la délivrance du brevet:
**18.02.2026 Bulletin 2026/08**

(21) Numéro de dépôt: **22844667.0**

(22) Date de dépôt: **09.12.2022**

(51) Classification Internationale des Brevets (IPC):
**G01R 19/00** *(2006.01)*   **G01R 15/18** *(2006.01)*
**H03M 1/06** *(2006.01)*   **H03M 1/12** *(2006.01)*
**H03H 11/04** *(2006.01)*

(52) Classification Coopérative des Brevets (CPC):
**G01R 19/0092; G01R 19/0007;** G01R 15/181

(86) Numéro de dépôt international:
**PCT/FR2022/052307**

(87) Numéro de publication internationale:
**WO 2023/111431 (22.06.2023 Gazette 2023/25)**

(54) **PROCEDE DE MESURE DE COURANT COMPORTANT UNE RECOMBINAISON NUMERIQUE D'UN SIGNAL DE COURANT BASSE FREQUENCE ET D'AU MOINS UN SIGNAL DE COURANT HAUTE FREQUENCE**

VERFAHREN ZUR MESSUNG EINER DIGITALEN STROMREKOMBINATION EINES NIEDERFREQUENTEN STROMSIGNALS UND MINDESTENS EINES HOCHFREQUENTEN STROMSIGNALS

METHOD FOR MEASURING A CURRENT DIGITALLY RECOMBINING A LOW-FREQUENCY CURRENT SIGNAL AND AT LEAST ONE HIGH-FREQUENCY CURRENT SIGNAL

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.12.2021 FR 2113452**

(43) Date de publication de la demande:
**23.10.2024 Bulletin 2024/43**

(73) Titulaire: **Safran Electrical & Power**
**31702 Blagnac Cedex (FR)**

(72) Inventeurs:
• **BALBINOT, Jean-Pierre**
**31702 Blagnac (FR)**
• **GUINDE, Guillaume**
**31702 Blagnac (FR)**

(74) Mandataire: **Ernest Gutmann - Yves Plasseraud S.A.S.**
**c/o Plasseraud IP**
**CS92104**
**104 Rue de Richelieu**
**75080 Paris Cedex 02 (FR)**

(56) Documents cités:
**DE-B3- 102019 120 666**   **FR-A1- 3 108 986**
**US-A1- 2015 070 008**   **US-A1- 2015 219 692**

EP 4 449 134 B1

**Description**

**Domaine technique**

La présente divulgation concerne les mesures réalisées à partir de capteurs de courant notamment de capteurs de courant embarqués dans le domaine de l'avionique et prévoit en particulier un procédé de mesure de courant comportant une recombinaison numérique d'un signal de courant basse fréquence, issu d'un capteur de courant basse fréquence, et d'au moins un signal de courant haute fréquence, issu d'un capteur de courant haute fréquence.

**Technique antérieure**

Il est connu de réaliser des mesures de courants à partir de capteurs de courants en utilisant des composants électroniques analogiques. Ces composants entraînent des problèmes de précision et de stabilité en température et nécessitent une correction de tension d'offset avec un temps relativement long de stabilisation. La tension d'offset est mesurée en intégrant le signal mesuré pour en déterminer la valeur moyenne et il est nécessaire d'avoir un intégrateur de grande constante de temps, quelques secondes. Ceci a pour conséquence de devoir attendre un temps de stabilisation équivalent avant de pouvoir disposer du résultat de la mesure, ce qui est pénalisant notamment en cas de microcoupures de l'alimentation de l'électronique du capteur telles que des microcoupures dues à des démarrages de dispositifs de puissance ou des commutations de puissance sur le réseau électrique de l'aéronef. Des exemples de capteurs de courant connus peuvent être trouvés dans US 2015/070008 A1, DE 10 2019 120666 B3, FR 3 108 986 A1 et US 2015/219692 A1.

**Exposé de l'invention**

Au vu de l'art antérieur la présente demande propose un dispositif de mesure destiné à s'affranchir de l'accumulation des dispersions liées aux composants analogiques en réalisant un système numérique se contentant de très peu de composants discrets et de réduire sensiblement le temps de stabilisation de la correction de la tension d'offset.

Dans cette optique la présente invention concerne un procédé de mesure de courant comportant une recombinaison numérique d'un signal de courant basse fréquence IBF issu d'un capteur de courant basse fréquence et d'au moins un signal de courant haute fréquence IHF issu d'un capteur de courant haute fréquence mesurés sur une même ligne électrique, ledit courant haute fréquence étant additionné à un offset continu parasite, qui comporte des étapes:

a. - d'amplification numérique dudit signal haute fréquence avec un amplificateur de gain G ce qui produit un signal haute fréquence amplifié G.IHF+G·offset,

b. - de premier filtrage au moyen d'un filtre passe bas numérique pourvu d'une fréquence de coupure fc dudit signal haute fréquence pour obtenir un signal haute fréquence amplifié filtré Ihf+G·offset,

c. - de deuxième filtrage dudit signal de courant basse fréquence IBF avec un filtre passe bas numérique pourvu de ladite fréquence de coupure fc pour obtenir un signal basse fréquence filtré Ibf;

d. - de première sommation du signal haute fréquence amplifié filtré Ihf+G-offset avec le signal de courant basse fréquence filtré Ibf et de filtrage à la fréquence fc de la somme desdits signaux pour obtenir un signal Ibf+Ihf+G·offset,

e. - de troisième filtrage dudit signal Ibf+Ihf+G·offset pour obtenir un signal Ibf+G·offset duquel la composante Ihf est supprimée,

f. - de multiplication par deux du signal Ibf pour obtenir un signal 2·Ibf ;

g. - de sommation/soustraction des signaux 2.Ibf+(Ihf+G·offset)-(Ibf+G·offset).

Selon ce procédé les signaux BF et HF sont remis à l'échelle et additionnés sans introduction d'un offset parasite sur le signal HF.

Les caractéristiques exposées dans les paragraphes suivants correspondent à des modes de réalisation pouvant être mises en œuvre indépendamment les uns des autres ou en combinaison les uns avec les autres:

Lesdites étapes peuvent avantageusement être précédées d'une étape de conversion analogique/numérique dudit signal de courant basse fréquence et d'une étape de conversion analogique/numérique dudit signal de courant haute fréquence, lesdites étapes de conversion étant réalisées sur un signal basse fréquence numérisé et un signal haute fréquence numérisé.

La fréquence de coupure fc est avantageusement la fréquence de coupure du signal Ibf ce qui donne une continuité de mesure entre la basse fréquence et la haute fréquence.

L'invention concerne en outre un dispositif de mise en œuvre du procédé qui comporte des moyens de calcul configurés pour implémenter des étapes du procédé.

Lesdits moyens de calcul peuvent comporter des moyens de conversion analogique/numérique des signaux.

Le dispositif peut en outre comporter un calculateur adapté à traiter les données numérisées de courants mesurés.

La présente divulgation concerne en outre un aéronef pourvu d'un dispositif de mesure tel que défini ci avant.

**Brève description des dessins**

D'autres caractéristiques, détails et avantages de l'invention apparaîtront à la lecture de la description détaillée ci-après d'exemples de réalisation non limitatifs, et à l'analyse des dessins annexés, sur lesquels :

[Fig. 1] montre un diagramme de Bode applicable dans le cadre de l'invention;

[Fig. 2] montre une vue schématique simplifiée d'un dispositif de l'art antérieur;

[Fig. 3] montre une vue schématique d'un dispositif de la présente divulgation;

[Fig. 4] montre une vue schématique de chaînage de dispositifs de la présente divulgation.

**Description des modes de réalisation**

Les dessins et la description ci-après contiennent des éléments pouvant non seulement servir à mieux faire comprendre la présente invention, mais aussi contribuer à sa définition, le cas échéant.

Dans le cas de l'utilisation de capteurs de courant non intrusifs, sur des lignes de courant de forte puissance par exemple, une mesure de courants basse fréquence est possible à l'aide de capteurs de type Néel. Ces capteurs ont une bonne linéarité du continu jusqu'à quelques centaines de Hertz. Par contre si l'on souhaite mesurer aussi des courants de fréquence plus élevée sur la même ligne, jusqu'au mégahertz par exemple, d'autres technologies de capteurs sont nécessaires comme les capteurs de type Rogowski.

Si l'on souhaite une mesure du continu jusqu'au mégahertz, il est souhaitable de combiner les deux technologies et un problème de compatibilité des mesures apparaît pour linéariser les résultats des deux mesures du fait que les deux technologies de capteurs et de mesures les utilisant n'ont pas le même gain.

Un but de la présente divulgation est d'accroître la bande passante de détection sur un même signal avec par exemple un capteur à bande passante très faible par exemple un capteur effet Néel d'une bande passante d'une centaine de Hertz et un capteur à bande passante plus élevée jusqu'au mégahertz par exemple.

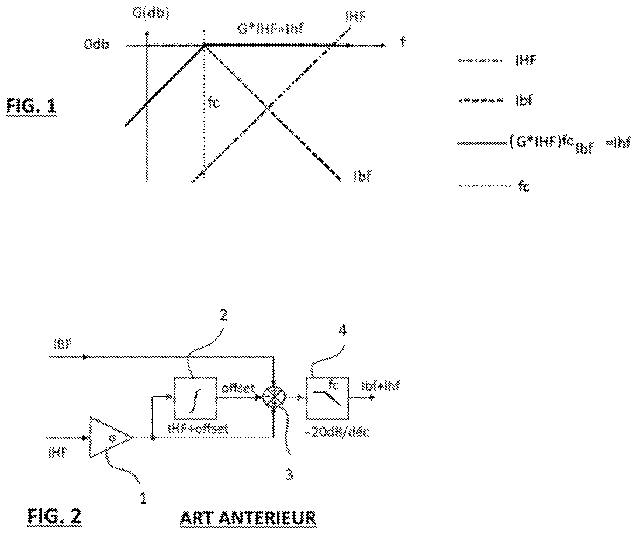

Le principe de la combinaison d'un signal de courant issu d'un capteur basse fréquence avec un signal de courant issu d'un capteur haute fréquence selon la présente divulgation est donné en figure 1 qui représente le principe utilisé par un diagramme de Bode gain G - fréquence f avec la combinaison d'un courant BF et d'un courant HF issu d'un capteur de type dérivateur.

Dans cette figure 1, le courant ibf peut être issu d'un capteur à effet Néel et le courant IHF peut être un courant issu d'un capteur fournissant la dérivée du courant HF, par exemple un capteur de type Rogowski. Pour le remettre à l'échelle, ce courant IHF est amplifié avec un gain G et filtré par un filtre passe-bas avec une fréquence de coupure fc qui est la fréquence de coupure du signal Ibf. On obtient ainsi $(G \cdot IHF)f_{CIbf}= Ihf$ qu'il suffit à ajouter à Ibf pour obtenir un courant dont la bande passante est équivalente à celle des 2 courants originaux.

Le problème soulevé par un dispositif à deux capteurs de bande passante différente recombinés est que l'imperfection de l'électronique utilisée pour mesurer et amplifier le signal HF introduit une tension d'offset additionnée à IHF ce qui ajoute un signal d'erreur continu ou offset au courant HF mesuré. Il est donc impératif d'évaluer cet offset afin de le soustraire au courant calculé.

Une solution de l'art antérieur telle que décrite en figure 2 est d'utiliser un intégrateur analogique dont la sortie est la valeur moyenne du courant IHF amplifié et en utilisant les fonctions suivantes :

Le signal IHF est amplifié par l'amplificateur 1 de gain G ce qui donne :

$$G \cdot IHF + G \cdot offset \ (1) \ ;$$

Le signal résultant est intégré au niveau de l'intégrateur 2 qui donne le signal :

$$G \cdot offset\ (2)\ ;$$

Un sommateur/soustracteur 3 combine les signaux IBF + G·IHF + G·offset - G·offset ce qui donne le résultat :

$$IBF + G \cdot IHF\ (3)\ ;$$

Ce signal est alors filtré dans un filtre passe bas 4 de fréquence de coupure fc et de pente -20db/décade selon l'exemple pour obtenir Ibf + Ihf.

Le problème se pose lorsque l'on mesure un courant à composante principale continue. Un tel signal nécessite un intégrateur à très basse fréquence qui nécessite un temps de stabilisation d'autant plus important que la fréquence est basse.

Aussi une solution selon la présente divulgation est de se passer d'intégrateur analogique en utilisant, après numérisation des signaux, un procédé de calcul comportant les opérations suivantes et en l'intégrant dans un composant numérique 20 adapté à réaliser du traitement de signal:

- Le signal IBF est converti par un convertisseur analogique/numérique 12 puis filtré par une fonction de filtre passe bas numérique 7 à la fréquence de coupure fc ce qui donne :

$$Ibf\ (4),$$

- Le signal IHF est converti par un convertisseur analogique/numérique 13 puis amplifié par un une fonction d'amplification 5 de gain G et filtré par une fonction de filtre passe bas numérique 6 à la fréquence de coupure fc ce qui donne un courant Ihf additionné à un offset multiplié par le gain G :

$$Ihf + G \cdot offset\ (5),$$

- Les 2 résultats précédents sont additionnés dans une fonction somme 10 ce qui donne :

$$Ibf + Ihf + G \cdot offset\ (6),$$

- Ce résultat est filtré par une fonction de filtre passe bas numérique 9 à la fréquence de coupure fc ce qui donne :

$$Ibf + G \cdot offset\ (7),$$

- En multipliant Ibf par deux par une opération de multiplication 8 on obtient 2·(4) qui est ajouté à (5) - (7) et on a :

$$2 \cdot Ibf + (Ihf + G \cdot offset) - (Ibf + G \cdot offset) = Ibf + Ihf\ (8)$$

dans l'opération de sommation/soustraction 11.

Grâce à ce procédé de calcul, le temps de stabilisation n'est plus lié à un intégrateur à grande constante de temps mais uniquement à la constante de temps du filtre passe-bas de fréquence fc ce qui permet des calculs beaucoup plus rapides. L'implémentation numérique de ce dispositif permet d'assurer le maximum de précision pour les calculs de gain ainsi que pour les filtres passe-bas qui peuvent être dupliqués sans aucune erreur, ce qui n'est pas le cas si cela devait être réalisé de manière analogique sachant qu'il est difficile de disposer exactement des mêmes composants entre les différentes fonctions.

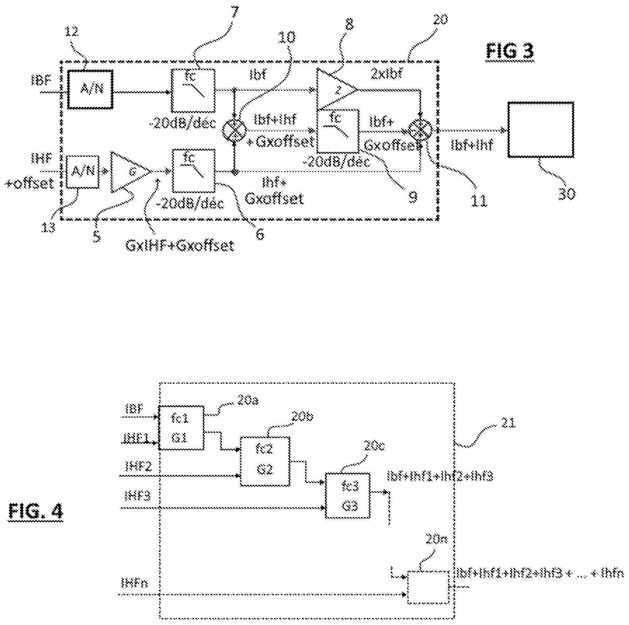

De plus, il est possible de chaîner plusieurs dispositifs de ce type comme représenté en figure 4 soit en chainant des processeurs numériques de signaux 20a, 20b, 20c, ..., 20n dont le premier reçoit un signal basse fréquence IBF et un premier signal haute fréquence IHF1 et comporte une fréquence de coupure fc1 et un gain G1, le deuxième reçoit la sortie ibf+ihf du premier et un signal IHF2 et comporte toujours une fréquence de coupure fc1 et un gain égal ou différent du gain G1, ce ainsi de suite pour les signaux IHF3, ..., IHFn suivants. soit en les regroupant dans un unique processeur de signal numérique muni d'un nombre d'entrées avec convertisseurs analogique/numérique suffisant afin d'étendre la bande passante du courant mesuré.

Le dispositif de la présente divulgation permet par exemple de combiner les signaux issus d'une sonde de courant basse fréquence, par exemple une sonde de courant à effet Néel et les signaux issus d'une sonde de courant haute fréquence comme une sonde de courant de type Rogowski.

Il est possible de réaliser un tel dispositif de mesure numérique avec un microcontrôleur pourvu de moyen de calcul réalisant les calculs correspondant aux filtres numériques, multiplications et additions ou soustractions ou bien sous forme de fonctions numériques intégrées dans un composant FPGA (Field Programmable Gate Array ou réseau de circuits logiques programmables en français) ou dans un composant de type DSP (Digital Signal Processor, processeur de signaux numériques).

Les données numérisées de courants peuvent être traitées dans un calculateur 30, qui peut être un calculateur de surveillance de réseau électrique relié à un dispositif de surveillance pouvant comporter des moyens d'affichage pour afficher les données de tension/courant réseau et/ou des moyens de communication pour communiquer les données à un système de surveillance.

La présente divulgation s'applique notamment à la protection de réseaux courant continu générés à partir de courants alternatifs de génératrices avion de fréquence 400 Hz - 800 Hz redressés, notamment de réseaux de traction forte tension fort courant avec protection sur pics HF. La présente divulgation concerne en outre un aéronef pourvu d'un dispositif de mesure tel que défini ci avant.

## Revendications

1. Procédé de mesure de courant comportant une recombinaison numérique d'un signal de courant basse fréquence IBF issu d'un capteur de courant basse fréquence et d'au moins un signal de courant haute fréquence IHF issu d'un capteur de courant haute fréquence mesurés sur une même ligne électrique, ledit courant haute fréquence étant additionné à un offset continu parasite, qui comporte des étapes:

   a. - d'amplification numérique dudit signal haute fréquence avec un amplificateur de gain G ce qui produit un signal haute fréquence amplifié G·IHF+G·offset,
   b. - de premier filtrage (6) au moyen d'un filtre passe bas numérique pourvu d'une fréquence de coupure fc dudit signal haute fréquence pour obtenir un signal haute fréquence amplifié filtré Ihf+G·offset,
   c. - de deuxième filtrage (7) dudit signal de courant basse fréquence IBF avec un filtre passe bas numérique pourvu de ladite fréquence de coupure fc pour obtenir un signal basse fréquence filtré Ibf;
   d. - de première sommation (10) du signal haute fréquence amplifié filtré Ihf+G·offset avec le signal de courant basse fréquence filtré Ibf et de filtrage à la fréquence fc de la somme desdits signaux pour obtenir un signal Ibf+Ihf+G·offset,
   e. - de troisième filtrage (9) dudit signal Ibf+Ihf+G·offset pour obtenir un signal Ibf+G·offset duquel la composante Ihf est supprimée,
   f. - de multiplication par deux du signal Ibf pour obtenir un signal 2·Ibf ;
   g. - de sommation/soustraction (11) des signaux 2.Ibf+(Ihf+G·offset)-(Ibf+G·offset).

2. Procédé de mesure de courant selon la revendication 1, pour lequel lesdites étapes sont précédées d'une étape de conversion analogique/numérique dudit signal de courant basse fréquence et d'une étape de conversion analogique/numérique dudit signal de courant haute fréquence, lesdites étapes de conversion étant réalisées sur un signal basse fréquence numérisé et un signal haute fréquence numérisé.

3. Procédé de mesure de courant selon la revendication 1 ou 2, pour lequel la fréquence de coupure fc est la fréquence de coupure du signal Ibf.

4. Dispositif de mesure de courant **caractérisé en ce qu'**il comporte des moyens de calcul configurés pour implémenter le procédé de l'une quelconque des revendications précédentes.

5. Dispositif de mesure de courant selon la revendication 4 pour lequel lesdits moyens de calcul comportent des moyens de conversion analogique/numérique des signaux.

6. Dispositif de mesure de courant selon la revendication 4 ou 5 **caractérisé en ce qu'**il comporte un calculateur (30) adaptés à traiter les données numérisées de courants mesurés.

7. Aéronef comprenant un dispositif de mesure selon l'une quelconque des revendications 4 à 6.

**Patentansprüche**

1. Strommessverfahren, umfassend eine digitale Rekombination eines niederfrequenten Stromsignals IBF von einem niederfrequenten Stromsensor und mindestens eines hochfrequenten Stromsignals IHF von einem hochfrequenten Stromsensor, gemessen an derselben Stromleitung, wobei dem hochfrequenten Strom ein parasitärer Gleichstrom-Offset hinzugefügt wird, umfassend die folgenden Schritte:

   a. - digitale Verstärkung des hochfrequenten Signals mit einem Verstärker G, wodurch ein verstärktes hochfrequentes Signal G·IHF+G·offset erzeugt wird,
   b. - erste Filterung (6) mittels eines digitalen Tiefpassfilters mit einer Grenzfrequenz fc für das hochfrequente Signal, um ein gefiltertes, verstärktes hochfrequentes Signal Ihf+G·offset zu erhalten,
   c. - zweite Filterung (7) des niederfrequenten Stromsignals IBF mit einem digitalen Tiefpassfilter mit der Grenzfrequenz fc, um ein gefiltertes niederfrequentes Signal Ibf zu erhalten,
   d. - erste Summierung (10) des gefilterten, verstärkten hochfrequenten Signals Ihf+G-Offset mit dem gefilterten niederfrequenten Stromsignal Ibf und Filterung der Summe dieser Signale bei der Frequenz fc, um ein Signal Ibf+Ihf+G·offset zu erhalten,
   e. - dritte Filterung (9) des Signals Ibf+Ihf+G·offset, um ein Signal Ibf+G·offset zu erhalten, aus dem der Ihf-Anteil entfernt wurde,
   f. - Multiplikation des Signals Ibf mit zwei, um ein Signal 2·Ibf zu erhalten,
   g. - Summierung/Subtraktion (11) der Signale 2·Ibf+(Ihf+G·offset)-(Ibf+G·offset).

2. Strommessverfahren nach Anspruch 1, wobei den genannten Schritten eine Analog-Digital-Wandlung des niederfrequenten Stromsignals und eine Analog-Digital-Wandlung des hochfrequenten Stromsignals vorausgehen, wobei die Wandlungsschritte an einem digitalisierten niederfrequenten Signal und einem digitalisierten hochfrequenten Signal ausgeführt werden.

3. Strommessverfahren nach Anspruch 1 oder 2, wobei die Grenzfrequenz fc die Grenzfrequenz des Signals Ibf ist.

4. Strommessgerät, **dadurch gekennzeichnet, dass** es Rechenmittel zur Durchführung des Verfahrens nach einem der vorhergehenden Ansprüche umfasst.

5. Strommessgerät nach Anspruch 4, wobei die Rechenmittel Mittel zur Analog-Digital-Wandlung der Signale umfassen.

6. Strommessgerät nach Anspruch 4 oder 5, **dadurch gekennzeichnet, dass** es einen Computer (30) zur Verarbeitung der digitalisierten Daten der gemessenen Ströme umfasst.

7. Luftfahrzeug, umfassend ein Messgerät nach einem der Ansprüche 4 bis 6.


**Claims**

1. A process for current measurement, comprising a digital recombination of a low frequency current signal ILF coming from a low frequency current sensor and at least one high-frequency current signal IHF coming from a high-frequency sensor measured on a single electrical line, where a parasitic continuous offset is added to said high-frequency current, which comprises steps:

   a. - digitally amplifying said high-frequency signal with an amplifier having gain G which produces an amplified high-frequency signal: G·IHF+G·offset;
   b. - first filtering (6) of said high-frequency signal by means of a digital low-pass filter with a cutoff frequency fc to get a filtered amplified high-frequency signal Ihf+G·offset:
   c. - second filtering (7) of said low-frequency current signal ILF with a digital low-pass filter provided with said cutoff frequency fc in order to get a filtered low-frequency signal: Ilf;
   d. - first summing (10) of the filtered amplified high-frequency signal Ihf+G·offset with the filtered low-frequency current Ilf and filtering of the sum of said signals at frequency fc resulting in a signal: Ilf+Ihf+G·offset;
   e. - third filtering (9) of said signal Ilf+Ihf+G·offset resulting in a signal Ilf+G·offset from which the Ihf component is deleted;

    f. - multiplying the signal Ilf by two resulting in a signal: 2 Ilf;

    g. - adding/subtracting (11) signals: 2 Ilf+(Ihf+G·offset)-(Ilf+G·offset).

2. The process for current measurement according to claim 1 for which said steps are advantageously preceded by a step of analog-to-digital conversion of said low-frequency current and a step of analog-to-digital conversion of said high-frequency current, where said conversion steps are done on a digitized low-frequency signal and a digitized high-frequency signal.

3. The process for current measurement according to claim 1 or 2, for which the cutoff frequency fc is the cutoff frequency of the signal Ilf.

4. A device for current measurement **characterized in that** it comprises calculation means configured for implementing the process from any one of the preceding claims.

5. The device for current measurement according to claim 4 for which said calculation means comprise means for analog-to-digital conversion of the signals.

6. The device for current measurement according to claim 4 or 5 **characterized in that** it comprises a processor (30) suited for processing the data digitized from measured currents.

7. An aircraft comprising a measurement device according to any one of claims 4 to 6.

FIG. 1

IHF

ibf

(G*IHF)fc$_{ibf}$ =Ihf

fc

FIG. 2          ART ANTERIEUR

**FIG 3**

IBF → [A/N] 12 → [TC -20dB/déc] 7 → Ibf → ⊗ 10 → Ibf+Ihf +Gxoffset → [TC -20dB/déc] 8 → Ibf+ Gxoffset → ⊗ 11 → 2xIbf → Ibf+Ihf → [ ] 30

IHF +offset → [A/N] 13 → [G] 5 → [TC -20dB/déc] 6 → Ihf+ Gxoffset

GxIHF+Gxoffset

9 20

**FIG. 4**

IBF →
IHF1 → [fc1 G1] 20a →
IHF2 → [fc2 G2] 20b →
IHF3 → [fc3 G3] 20c → Ibf+Ihf1+Ihf2+Ihf3

21

IHFn → [ ] 20n → Ibf+Ihf1+Ihf2+Ihf3 + ... + Ihfn

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2015070008 A1
- DE 102019120666 B3
- FR 3108986 A1
- US 2015219692 A1